# EUROPÄISCHE PATENTSCHRIFT

(11) **EP 2 728 985 B1**
(45) Veröffentlichungstag und Bekanntmachung des Hinweises auf die Patenterteilung: **31.01.2018**
(21) Anmeldenummer: 12197442.2
(22) Anmeldetag: 17.12.2012
(51) Int. Cl.: H05K 5/02, H05K 5/06

(54) **Stellantrieb mit elektrischer Steckverbindung**
Actuator with electrical plug-in connection
Entraînement de réglage avec raccord enfichable électrique

(30) Priorität: 02.11.2012 EP 12191096
(43) Veröffentlichungstag der Anmeldung: 07.05.2014
(73) Patentinhaber: Siemens Schweiz AG, 8047 Zürich (CH)
(72) Erfinder: Anderson, Dean B., Wonder Lake, 60097 (US); Grossenbacher, Christian, 5622 Waltenschwil (CH); Kälin, Beat, 8840 Einsiedeln (CH); Pally, Andreas, 6319 Allenwinden (CH)
(74) Vertreter: Maier, Daniel Oliver

(56) Entgegenhaltungen:
- EP-A1- 1 215 950
- EP-A1- 1 528 656
- DE-A1- 2 434 892
- DE-A1- 19 851 455
- DE-A1-102004 060 694

## Beschreibung

Die Erfindung bezieht sich auf einen Stellantrieb der im Oberbegriff des Anspruchs 1 genannten Art. Weiterhin bezieht sich die Erfindung auf ein Anschlussmodul für eine Kabelzuführung zu einem solchen Stellantrieb. Ausserdem bezieht sich die Erfindung auf eine Anordnung für den Antrieb von Stellgliedern, umfassend einen Stellantrieb sowie ein Anschlussmodul für eine Kabelzuführung zum Stellantrieb.

Solche Stellantriebe werden vorteilhaft in der Heizungs-, Lüftungs- und Klimatechnik zur Betätigung von Stellgliedern, wie Lüftungsklappen, Ventile oder dergleichen, verwendet. Ein Gehäuse für einen derartigen Stellantrieb muss insbesondere elektromechanische und elektronische Komponenten des Stellantriebs vor Verschmutzung und Spritzwasser schützen. Ein Stellantrieb ist z.B. in der deutschen Patentanmeldung DE19516973A1 beschrieben.

Die europäische Patentanmeldung EP1528656A1 offenbart einen elektromotorischen Stellantrieb mit Gehäuse und Motor. Weiterhin offenbart EP1528656A1 ein Trägerplattengehäuse und einen Trägerplattengehäusedeckel, wobei zwischen Trägerplattengehäuse und einen Trägerplattengehäusedeckel eine Trägerplatte vorgesehen, die als elektrische Leiterplatte ausgeführt ist und mit einer Steckeraufnahme gekoppelt ist.

Ein Stellantrieb mit Gehäuse und Abdichtung ist z.B. aus der europäischen Patentanmeldung EP1215950A1 bekannt.

Die deutsche Patentanmeldung DE19851455A1 offenbart ein Elektronikmodul für eine elektromotorisch betriebene Antriebseinheit, insbesondere für einen elektromotorischen Fensterheber eines Kraftfahrzeugs, umfassend ein am Gehäuse der Antriebseinheit festlegbares Elektronikgehäuseteil mit einem daran angeordneten (ersten) Steckerteil und einem zweiten Steckerteil.

Die deutsche Patentanmeldung DE2434892 offenbart ein Gehäuse für elektronische Baugruppen in Quaderform mit einer als Deckel abnehmbaren Seitenflache und Mitteln zum Befestigen an einem Träger, wobei das Gehäuse an wenigstens einer Seitenflache mit sich vom Gehäuserand her erstreckenden Durchbrechungen versehen ist, deren senkrecht zum Gehäuserand verlaufende Ränder als Führungen für einschiebbare Wandteile gestaltet sind, und wobei die eingeschobenen Wandteile von dem aufschnappbaren Deckel gehalten und vorzugsweise als Durchführungen für Anschlussmittel ausgebildet sind.

Die deutsche Patentanmeldung DE102004060694A1 offenbart eine elektronische Vorrichtung mit einem Gehäuse zur Aufnahme eines eine elektronische Schaltung tragenden Trägersubstrates, wobei die elektronische Schaltung mit mindestens einer elektrischen Leitung kontaktiert ist, welche aus dem Gehäuse herausgeführt ist, wobei die elektrische Leitung mit einem starren Kontaktelement eines Kontakthalters verbunden ist und das Kontaktelement zur Kontaktierung der elektronischen Schaltung in das Trägersubstrat eingeführt ist.

Über elektrische Kabelanschlüsse werden die elektronischen Komponenten des Stellglieds üblicherweise mit Strom versorgt. Der elektrische Anschluss kann dabei z.B. durch Lüsterklemmen erfolgen. In der deutschen Patentschrift DE19627988C1 ist eine elektrische Steckverbindung für den Antrieb von beweglichen Einrichtungen wie Türen, Tore, Rollläden, Markisen etc. offenbart, die eine in elektrischer Hinsicht sichere Bedienbarkeit gewährleisten soll. Die in DE19627988C1 offenbarte Lösung ist aber nur für bestimmte Typen von Kabelanschlüssen geeignet.

Es ist daher die Aufgabe der vorliegenden Erfindung, einen Stellantrieb zur Betätigung von Stellgliedern, wie Lüftungsklappen, Ventile oder dergleichen, bereitzustellen, dessen elektrische Stromversorgung über unterschiedliche Typen von Kabelanschlüssen erfolgen kann.

Die Aufgabe wird gelöst durch einen Stellantrieb mit einem Gehäuse, welches ein erstes Gehäuseteil und ein zweites Gehäuseteil aufweist, wobei die beiden Gehäuseteile je einen Rand mit je einer Stirnfläche aufweisen und wobei beim Zusammenfügen der beiden Gehäuseteile die beiden Stirnflächen sich gegenüberliegen, wobei das erste Gehäuseteil und das zweite Gehäuseteil lösbar zusammenfügbar sind, der Stellantrieb ausgebildet ist, ein wechselbares Anschlussmodul für eine Kabelzuführung aufzunehmen, wobei das wechselbares Anschlussmodul in einer Ausnehmung des ersten Randes des ersten Gehäuseteils einsetzbar ist und wobei beim Zusammenfügen der beiden Gehäuseteile das wechselbare Anschlussmodul mit den Stirnflächen der Ränder in einem Bereich der Ausnehmung formschlüssig verbindbar ist, dadurch gekennzeichnet, dass das Anschlussmodul für die elektrische Stromversorgung unterschiedlich ausgebildet sein kann, wobei auch das zweite Gehäuseteil eine Ausnehmung des zweiten Randes, zur zusammen mit der Ausnehmung des ersten Randes zusammenwirkenden Aufnahme des Anschlussmoduls, aufweist. Der Stellantrieb ist vielseitig verwendbar, z.B. für Lüftungsanwendungen oder für Brandschutzklappen. Das Anschlussmodul für die elektrische Stromversorgung kann unterschiedlich ausgebildet sein und kundenseitig oder werkseitig am Stellantrieb montiert werden. Es ist somit möglich, die Stromversorgung an einem am Einsatzort vormontierten Stellglied nachträglich auf einfache Weise anzuschliessen. Das Gehäuse kann z.B. aus Kunststoff oder durch Leichtmetallguss (z.B. Aluminium) gefertigt sein. Der Stellantrieb kann mit Federrücklauf (Sicherheitsfunktion, z.B. Notstellfunktion für eine Klappe) oder ohne Federrücklauf verwendet werden. Der Stellantrieb ist somit lageunabhängig montierbar.

Eine erste vorteilhafte Ausgestaltung der Erfindung liegt darin, dass für das Einsetzen des Anschlussmoduls eine Nut-/Wulst-Verbindung verwendet wird, wobei die Stirnflächen der Ränder im Bereich der Ausnehmung eine umlaufende Wulst bilden und wobei das Anschlussmodul zum Einsetzen in die Ausnehmung eine umlaufende Nut zum formschlüssigen Aufnehmen der Wulst aufweist, wobei die Nut durch eine erste Rippe und eine zweite Rippe gebildet wird, wobei nach dem Einsetzen des Anschlussmoduls und dem Zusammenfügen der beiden Gehäuseteile die erste Rippe an einen Gehäuseinnenraum grenzt und die zweite Rippe am Gehäuse gegen außen anliegt. Die Nut-/Wulst-Verbindung ermöglicht eine einfache Steckmontage des Anschlussmoduls im Stellantrieb. Durch die Formschlüssigkeit entsteht ein wirksamer Schutz gegen Spritzwasser und Verschmutzung im Innenraum des Stellantriebs, d.h. innerhalb des Gehäuses. Optional könnte über die gesamte Stirnfläche oder im Bereich der Nut-/Wulst-Verbindung ein Dichtelement (z.B. eine Gummidichtung) angebracht werden, um z.B. eine luftdichte Versiegelung des Innenraums des Gehäuses zu erhalten. Nut-/Wulst-Verbindungen sind leicht herstellbar, z.B. durch Formgießen. Vorteilhafterweise werden die vorhandenen Stirnflächen der Ränder im Bereich der Ausnehmung als umlaufende Wulst verwendet. Die Wulst muss somit nicht in einem extra Arbeitsgang am Gehäuse angebracht werden.

Durch das Nut-Wulst Prinzip (d.h. durch die Dichtungsgeometrie einer Nut-/Wulst-Verbindung) entsteht mit grosser Wirkfläche eine hohe mechanische Festigkeit zwischen Anschlussmodul und Stellantrieb. Dies ist z.B. eine wichtige Voraussetzung für die erforderliche meachanische Belastbarkeit bei flexiblen Kabeln aber insbesondere bei starren Installationsrohrverbindungen (z.B. bei sog. Rigid-Conduit-Verschraubungen).

Nut-/Wulst-Verbindungen ermöglichen es u.a. schnell eine formschlüssige Verbindung (durch Einstecken oder Einschieben) herzustellen und weiterhin ermöglichen Nut-/Wulst-Verbindungen robuste Ausführungsformen des Stellantriebs.

Eine weitere vorteilhafte Ausgestaltung der Erfindung liegt darin, dass die zweite Rippe durch einen Körper des Anschlussmoduls gebildet wird. Somit kann ein Teil der Geometrie bzw. der räumlichen Ausgestaltung des Anschlussmoduls als zweite Rippe verwendet werden. Dies erleichtert die Herstellung des Gehäuses bzw. des Anschlussmoduls.

Eine weitere vorteilhafte Ausgestaltung der Erfindung liegt darin, dass der Stellantrieb ausgebildet ist, mehrere Anschlussmodule aufzunehmen. Anschlussmodule dienen der Zuführung für Anschlüsse für die Kommunikation (z.B. elektrisches Stellsignal für ein Stellglied (z.B. Lüfterklappe)) und/oder der Energieversorgung der elektrischen Komponenten (z.B. Motor) im Stellantrieb. Durch die Möglichkeit den Stellantrieb mit mehreren Anschlussmodulen zu versehen, kann der Stellantrieb skaliert ausgebildet werden, je nach Umgebungs- oder Kundenerfordernissen. So kann z.B. ein optionales zweites Anschlussmodul beispielsweise für einen Hilfsschalter, ein Rückführpotentiometer, ein Positionssensor oder ein Endlagerschalter vorgesehen sein oder alternativ bzw. zusätzlich ein Anschlussmodul für die Speisung eines Sensors (z.B. ein 24 Volt Ausgang für die Speisung eines Brandschutz- und/oder Temperatursensors. Solche Sensoren sind in Gebäuden üblicherweise zur Erkennung von Gefahrenkenngrößen vorhanden und können somit leicht elektrisch angeschlossen werden, ohne separate Verkabelung. Da die Netzspannung für den Hilfsschalter nicht über eine Leiterplatte geführt wird, ist es u.a. möglich das Gehäuse als Aluminiumgehäuse auszubilden.

Die Ausnehmungen für die optionalen Anschlussmodule können durch dafür vorgesehene Verschlusselemente (sog. Dummies) bei Nichtbenutzung formschlüssig (z.B. Nut-/Wulst-prinzip) abgeschlossen werden.

Eine weitere vorteilhafte Ausgestaltung der Erfindung liegt darin, dass auch das zweite Gehäuseteil eine Ausnehmung des zweiten Randes, zur zusammen mit der Ausnehmung des ersten Randes zusammenwirkenden Aufnahme des Anschlussmoduls, aufweist. Dadurch wird die Größe des Anschlussmoduls nicht durch die Höhe des ersten Randes begrenzt.

Eine weitere vorteilhafte Ausgestaltung der Erfindung liegt darin, dass durch das Anschlussmodul ein im Stellantrieb fest installiertes Kabel zugeführt wird. Stellantriebe mit durch das Anschlussmodul zugeführten fest installierten Kabeln weisen niedrige Herstellungskosten auf. Das Anschlussmodul wirkt dabei wie ein Klemmenblock oder Anschlussblock im Gehäuse. Ein oder mehrere Kabel können dabei durch Löcher im Anschlussmodul dem Stellantrieb zugeführt sein, wobei die Zugentlastung für die Kabel im Anschlussmodul realisierbar ist. Das Anschlussmodul besteht vorteilhafterweise aus einem Kunststoff (z.B. eine Gummiverbindung), der nach der Montage des Anschlussmoduls mit dem Gehäuse formschlüssig verbunden ist. Bei Bedarf ist das Kabel z.B. durch eine Klemmverbindung formschlüssig mit dem Anschlussmodul verbunden.

Eine weitere vorteilhafte Ausgestaltung der Erfindung liegt darin, dass das Anschlussmodul als einsetzbares Terminal mit einer Reihe von Anschlusskontakten zum Anschliessen elektrischer Komponenten im Gehäuse ausgestaltet ist. Das Anschlussmodul übernimmt dabei eine einfache Terminalfunktion, z.B. als fix eingesetztes Terminal mit Schutzklappe.

Eine weitere vorteilhafte Ausgestaltung der Erfindung liegt darin, dass die Anschlusskontakte durch eine sogenannte daisy-chain-Verbindung gekoppelt sind. Daisy-chain-Verbindungen sind leicht und kostengünstig herstellbar und insbesonders für sogenannte "low-cost"-Märkte geeignet.

Eine weitere vorteilhafte Ausgestaltung der Erfindung liegt darin, dass das Anschlussmodul als einsetzbares Schraubterminal, insbesondere für die Schutzklasse IP 54, ausgebildet ist. Das Anschlussmodul übernimmt dabei eine Terminalfunktion, z.B. als fix eingesetztes Schraubterminal mit Schutzklappe. Bei dem Schraubterminal kann es sich z.B. um eine metrische-, eine PG-Kabelverschraubung oder eine Conduit-Verschraubung handeln.

Eine weitere vorteilhafte Ausgestaltung der Erfindung liegt darin, dass das Anschlussmodul zweiteilig ausgebildet ist, wobei der erste Teil im Bereich der Ausnehmung formschlüssig in das Gehäuse einsetzbar ist und am Gehäuseaußenteil eine Buchse für eine Steckverbindung aufweist, und wobei der zweite Teil als steckbares Schraubterminal mit einer zur Buchse komplementären Gegensteckverbindung ausgebildet ist. Das steckbare Schraubterminal kann unabhängig vom mechanisch vormontierten Stellantrieb an geeigneter Stelle verdrahtet werden. Stellantriebe werden oft an schwer zugänglichen Stellen wie Zwischendecken mechanisch vormontiert und erst zu einem späteren Zeitpunkt elektrisch verdrahtet. Weiterhin ist eine gute Zugänglichkeit zu den Schraubterminals gewährleistet, insbesondere bei wendbaren Federrücklauf-Stellantrieben in beiden möglichen Montagepositionen. Bei einem entsprechend mechanisch vormontierten Stellantrieb ist somit eine vereinfachte 2-Hand-Montage (Draht / Schraubenzieher) möglich. Weiterhin kann der Stellantrieb ausgewechselt werden ohne vorgängige elektrische Abschaltung. Diverse Warnhinweise in der Montageanleitung oder auf dem Gehäuse können somit entfallen.

Eine weitere vorteilhafte Ausgestaltung der Erfindung liegt darin, dass das Anschlussmodul zweiteilig ausgebildet ist, wobei der erste Teil im Bereich der Ausnehmung formschlüssig in das Gehäuse einsetzbar ist und am Gehäuseaußenteil eine Buchse für eine Steckverbindung aufweist, und wobei der zweite Teil als steckbares Terminal mit einer zur Buchse komplementären Gegensteckverbindung ausgebildet ist, wobei das Terminal durch einen elektrisch isolierten Kunststoff an ein zugeführtes Kabel gespritzt ist. Auch dadurch kann der Stellantrieb ausgewechselt werden ohne vorgängige elektrische Abschaltung. Diverse Warnhinweise in der Montageanleitung oder auf dem Gehäuse können somit auch bei dieser Ausgestaltung entfallen.

Eine weitere vorteilhafte Ausgestaltung der Erfindung liegt darin, dass der Stellantrieb einen Schaltungsträger (z.B. Platine, Leiterplatte) mit Kontaktelementen umfasst, wobei die Kontaktelemente ausgebildet sind mit dazu komplementären Kontaktelementen des Anschlussmoduls beim Einsetzen des Anschlussmoduls eine elektrische Kontaktierung zu ermöglichen. Dadurch wird für die elektrische Kontaktierung ein Arbeitsschritt eingespart. Die elektrische Kontaktierung erfolgt automatisch durch das Einsetzen des Anschlussmoduls durch die Kontaktierung der Kontaktelemente. Das Einsetzen und die Kontaktierung erfolgen somit in einem gemeinsamen Arbeitsgang.

Eine weitere vorteilhafte Ausgestaltung der Erfindung liegt darin, dass für das Einsetzen des Anschlussmoduls eine Nut-/Wulst-Verbindung verwendet wird, wobei die Stirnflächen der Ränder im Bereich der Ausnehmung eine umlaufende Nut bilden und wobei das Anschlussmodul zum Einsetzen in die Ausnehmung eine umlaufende Wulst zum formschlüssigen Einsetzen in die Nut aufweist, wobei die Nut durch eine erste Rippe und eine zweite Rippe gebildet wird, wobei die erste Rippe an einem Gehäuseinnenraum anliegt und die zweite Rippe an einem Gehäuseaussenraum. Um eine Nut-/Wulst-Verbindung zur formschlüssigen Verbindung von Anschlussmodul und Gehäuse herzustellen, können somit die Nut und die Wulst entweder durch die Geometrie des Anschlussmoduls oder durch die Geometrie des Gehäuses gebildet werden.

Durch das Nut-Wulst Prinzip (d.h. durch die Dichtungsgeometrie einer Nut-/Wulst-Verbindung) entsteht mit grosser Wirkfläche eine hohe mechanische Festigkeit zwischen Anschlussmodul und Stellantrieb. Dies ist z.B. eine wichtige Voraussetzung für erforderliche meachanische Belastungstests bei Flexible- aber insbesondere bei Rigid-Conduit-Verschraubungen. Nut-/Wulst-Verbindungen ermöglichen es u.a. schnell eine formschlüssige Verbindung (durch Einstecken oder Einschieben) herzustellen und weiterhin ermöglichen Nut-/Wulst-Verbindungen robuste Ausführungsformen des Stellantriebs.

Die Aufgabe wird weiterhin gelöst durch ein Anschlussmodul für eine Kabelzuführung zu einem Stellantrieb, wobei das Anschlussmodul in einer Ausnehmung eines Randes eines Gehäuseteils einsetzbar ist und wobei beim Zusammenfügen der beiden Gehäuseteile das Anschlussmodul mit den Stirnflächen der Ränder in einem Bereich der Ausnehmung formschlüssig verbindbar ist. Die Verwendung solcher erfindungsgemäßen Anschlussmodule ermöglicht eine flexible elektrische Kontaktierung für Stellantriebe.

Die Aufgabe wird weiterhin gelöst durch eine Anordnung für den Antrieb von Stellgliedern, die Anordnung umfassend: einen Stellantrieb mit einem Gehäuse, welches ein erstes Gehäuseteil und ein zweites Gehäuseteil aufweist, wobei die beiden Gehäuseteile je einen Rand mit je einer Stirnfläche aufweisen und wobei beim Zusammenfügen der beiden Gehäuseteile die beiden Stirnflächen sich gegenüberliegen, wobei das erste Gehäuseteil und das zweite Gehäuseteil lösbar zusammenfügbar sind, und ein Anschlussmodul für eine Kabelzuführung zum Stellantrieb, wobei das Anschlussmodul in einer Ausnehmung des ersten Randes des ersten Gehäuseteils eingesetzt ist und wobei durch ein Zusammenfügen der beiden Gehäuseteile das wechselbare Anschlussmodul mit den Stirnflächen der Ränder in einem Bereich der Ausnehmung formschlüssig verbunden ist. Die erfindungsgemäße Anordnung ermöglicht die Verwendung unterschiedlicher Anschlussmodule für die elektrische Kontaktierung des Stellantriebs. Es ist somit eine flexible und auch auswechselbare elektrische Kontaktierung für Stellantriebe möglich.

Eine weitere vorteilhafte Ausgestaltung der Erfindung für eine Anordnung für den Antrieb von Stellgliedern liegt darin, dass das Anschlussmodul für die Kabelzuführung zum Stellantrieb in einer Ausnehmung eines Randes eines Gehäuseteils einsetzbar ist und wobei beim Zusammenfügen der beiden Gehäuseteile das Anschlussmodul mit den Stirnflächen der Ränder in einem Bereich der Ausnehmung formschlüssig verbindbar ist. Solche erfindungsgemäßen Anschlussmodule ermöglichen einen einfachen und flexiblen (unterschiedliche Anschlusstypen sind möglich) elektrischen Anschluss für Stellantriebe, insbesondere für den Antrieb von Stellgliedern.

Die Erfindung sowie vorteilhafte Ausführungen der vorliegenden Erfindung werden am Beispiel der nachfolgenden Figuren erläutert. Dabei zeigen:
- FIG 1: einen beispielhaften Stellantrieb mit einem Gehäuse,
- FIG 2: ein erstes beispielhaftes Gehäuseteil mit einem Rand,
- FIG 3: ein zweites beispielhaftes Gehäuseteil mit einem Rand,
- FIG 4: beispielhafte Gehäuseteile mit einem ersten beispielhaften Anschlussmodul,
- FIG 5, FIG 6: jeweils beispielhafte Gehäuseteile mit einem zweiten beispielhaften Anschlussmodul,
- FIG 7, FIG 8: jeweils beispielhafte Gehäuseteile mit einem dritten beispielhaften Anschlussmodul,
- FIG 9 - FIG 11: jeweils beispielhafte Gehäuseteile mit einem vierten beispielhaften Anschlussmodul, und
- FIG 12: einen beispielhaften Stellantrieb mit einem fünften beispielhaften Anschlussmodul.

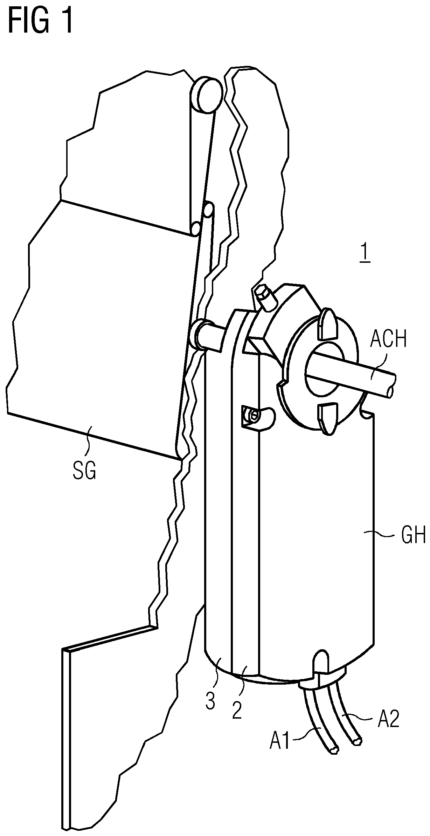

In der Figur 1 bedeutet 1 einen beispielhaften Stellantrieb zum Betätigen eines Stellgliedes SG. Das Stellglied SG - im Beispiel eine Lüftungsklappe - ist über eine drehbare Achse ACH betätigbar. Der Stellantrieb 1 weist ein Gehäuse GH mit einem ersten Gehäuseteil 2 und einem zweiten Gehäuseteil 3 auf. Die beiden Gehäuseteile 2 und 3 sind mit Vorteil durch Schrauben miteinander lösbar verbunden. Der Stellantrieb 1 weist eine Zuführung für Anschlüsse A1 und A2 auf. Die Anschlüsse A1 und A2 dienen der Kommunikation und/oder der Speisung. Typischerweise sind die Anschlüsse A1 und A2 für ein elektrisches Stellsignal. Bei Bedarf weist die Zuführung weitere Anschlüsse - beispielsweise zur Positionsrückmeldung oder zur Energieversorgung - auf. Die Geometrie und die Funktionalität des Gehäuses GH sind vorteilhafterweise einerseits auf zu schützende elektronische, elektrische und mechanische Bauelementen und - gruppen des Stellantriebs 1 und andrerseits auf die Anordnung des Stellantriebs 1 am Stellglied SG ausgerichtet, wobei u.a. eine kostengünstige aber sichere und funktionsgerechte Montage gewünscht ist.

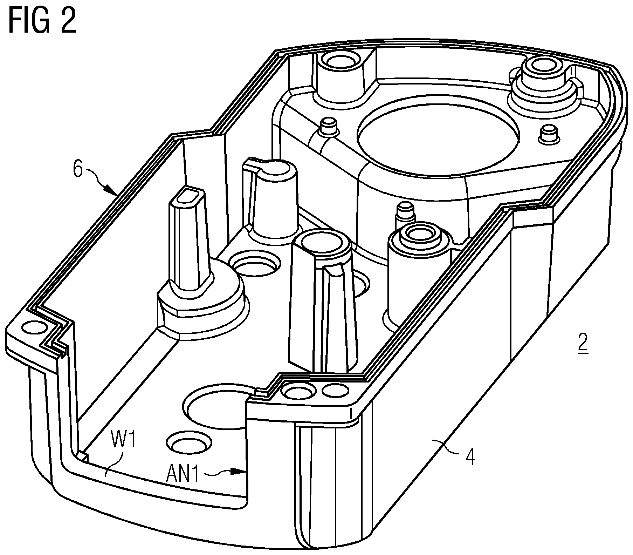

In der Figur 2 ist beispielhaft eine prinzipiell als Schale ausgebildete Ausführung des ersten Gehäuseteils 2 dargestellt. Das erste Gehäuseteil 2 weist einen hochgezogenen Rand 4 mit einer Stirnfläche 6 auf, durch die das erste Gehäuseteil 2 im Wesentlichen begrenzt ist. Mit Vorteil weist der hochgezogene Rand 4 eine Ausnehmung AN1 für die Zuführung einer Verkabelung auf. Mit Vorteil ist die Stirnfläche 6 des Gehäuseteils 2 insbesondere im Bereich der Ausnehmung AN1 als Wulst W1 ausgebildet, die in eine Nut einführbar ist.

Das erste Gehäuseteil 2 weist mit Vorteil Löcher für Schrauben auf, um das erste Gehäuseteil 2 mit dem zweiten Gehäuseteil 3 lösbar zu verbinden.

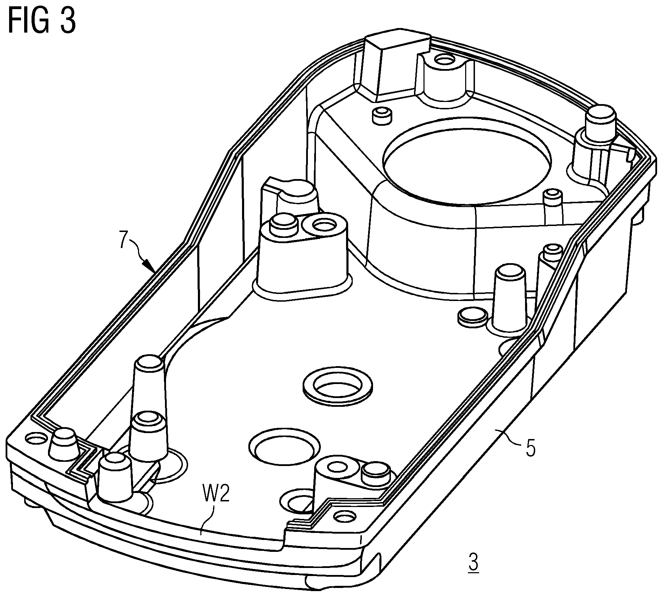

In der Figur 3 ist beispielhaft eine prinzipiell als Deckel ausgebildete Ausführung des zweiten Gehäuseteils 3 dargestellt. Das zweite Gehäuseteil 3 weist einen hochgezogenen Rand 5 mit einer Stirnfläche 7 auf, durch die das zweite Gehäuseteil 3 im Wesentlichen begrenzt ist. Optional weist auch der hochgezogene Rand 5 eine Ausnehmung für eine Zuführung auf. Das zweite Gehäuseteil 3 kann aber auch ohne Ausnehmung für eine Zuführung ausgebildet sein. Mit Vorteil ist auch die Stirnfläche 7 des Gehäuseteils 3 im Bereich einer optionalen Ausnehmung als Wulst W2 ausgebildet, als Gegenstück zu einer Nut. Weist das zweite Gehäuseteil 3 keine Ausnehmung auf, so ist vorteilhafterweise der Bereich der Stirnfläche 7 des zweiten Gehäuseteils 3, der im montierten Zustand der Ausnehmung AN1 des ersten Gehäuseteils 2 gegenüberliegt, als Wulst W2 ausgebildet. Auch das zweite Gehäuseteil 3 weist mit Vorteil Löcher für eine Schraubverbindung mit dem ersten Gehäuseteil 2 auf.

Das Gehäuse GH weist eine Abdichtung auf, wenn die beiden Gehäuseteile 2 und 3 derart zusammengefügt werden, dass die beiden Stirnflächen 6 und 7 sich gegenüberliegen, wobei das erste Gehäuseteil 2 und das zweite Gehäuseteil 3 lösbar und direkt aufeinander gelegt werden und zusammenschraubbar sind. Dies kann mit oder ohne zusätzliches Dichtungselement (z.B. Gummi, Paste) erfolgen. Somit erfolgt ein Schutz gegen Spritzwasser oder Verschmutzung.

Damit eine gute Passform zwischen den beiden Gehäuseteilen 2 und 3 erreicht und ein gegenseitiges Verschieben entlang des Randes 4 oder 5 verhindert wird, sind die Formen der beiden Stirnflächen 6 und 7 so aufeinander abzustimmen, dass ein gegenseitiger Anschlag ausgeformt ist. Die beiden Gehäuseteile 2 und 3 werden mit Vorteil durch mehrere Schrauben miteinander verbunden. Prinzipiell ist aber z.B. auch eine Steck-oder Schnappverbindung vorstellbar. Das Gehäuse GH wird mit Vorteil durch Giessen einer Leichtmetalllegierung hergestellt, beispielhaft durch Druckgiessen einer Aluminiumlegierung. Das Gehäuse GH kann aber auch aus Kunststoff hergestellt werden. Das Gehäuse GH kann z.B. im Spritzgussverfahren aus einem elektrisch isolierenden Kunststoff hergestellt werden, z.B. aus ABS.

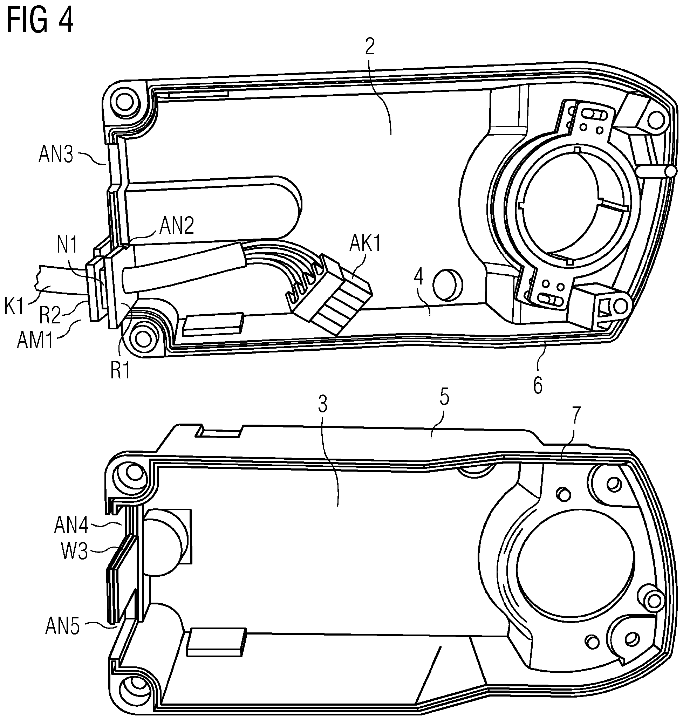

Figur 4 zeigt Gehäuseteile 2, 3 mit einem ersten beispielhaften Anschlussmodul AM1. In Figur 4 sind die Gehäuseteile 2, 3 einzeln (d.h. aufgeklappt bzw. offen) und nicht zu einem Gehäuse zusammen gesetzt dargestellt. Um ein zusammen gesetztes Gehäuse zu erreichen, müssten die Gehäuseteile 2 und 3 an den Stirnflächen 6, 7 im gegenseitigen Anschlag formschlüssig mit einander verbunden werden. Die Gehäuseteile 2, 3 weisen jeweils an ihren Ecken Ausnehmungen (Löcher) für Schraubverbindungen auf. In der Darstellung gemäß Figur 4 weisen die Gehäuseteile 2, 3 jeweils auf der rechten Seite eine runde Ausnehmung auf, für die Aufnahme der Achse zum Betätigen eines Stellglieds (z.B. eine Lüfterklappe oder Brandschutzklappe).

In der Darstellung gemäß Figur 4 weist das Gehäuseteil 2 zwei Ausnehmungen AN2, AN3 auf und das Gehäuseteil 3 die dazugehörigen Ausnehmungen AN4 und AN5 auf. Im zusammen gesetzten Zustand der Gehäuseteile 2, 3 bilden jeweils die Ausnehmungen AN2 und AN4, bzw. die Ausnehmungen AN3 und AN5 jeweils eine Zuführöffnung für das Anschlussmodul AM1. Eine zweite oder dritte Zuführöffnung für weitere Anschlussmodule AM1 ist optional. Es ist nicht notwendig, dass jedes Gehäuseteile 2, 3 Ausnehmungen AN2 - AN5 enthält. Ein Gehäuseteile 2, 3 kann z.B. nur als Deckel, d.h. ohne Ausnehmungen AN2 - AN5 ausgebildet sein.

In der Darstellung gemäß Figur 4 wird beispielhafter weise durch das Anschlussmodul AM1 ein im Stellantrieb fest installiertes Kabel K1 zugeführt. Durch das Kabel K1 erfolgt eine Kommunikation und/oder eine Stromversorgung der elektrischen Komponenten (z.B. Elektromotor), die sich innerhalb des Gehäuses des Stellantriebs befinden. Die elektrischen Komponenten werden durch die Anschlusskontaktierung AK1 versorgt.

Figur 4 zeigt ein erstes Gehäuseteil 2 und ein zweites Gehäuseteil 3 für einen Stellantrieb, wobei die beiden Gehäuseteile 2, 3 je einen Rand 4,5 mit je einer Stirnfläche 6, 7 aufweisen und wobei beim Zusammenfügen der beiden Gehäuseteile 2, 3 die beiden Stirnflächen 6, 7 sich gegenüberliegen, wobei das erste Gehäuseteil 2 und das zweite Gehäuseteil 3 lösbar und direkt oder mit einem Dichtungselement zusammenfügbar sind (z.B. durch eine Schraubverbindung), wobei das Gehäuse des Stellantriebs ausgebildet ist, ein wechselbares Anschlussmodul AM1 für eine Kabelzuführung K1 aufzunehmen, wobei das wechselbares Anschlussmodul AM1 in einer Ausnehmung AN2 oder AN3 des ersten Randes 4 des ersten Gehäuseteils 2 einsetzbar ist und wobei beim Zusammenfügen der beiden Gehäuseteile 2 und 3 das wechselbare Anschlussmodul AM1 mit den Stirnflächen 6, 7 der Ränder 4 und 5 der Gehäuseteile in einem Bereich der Ausnehmung AN2 oder AN3 formschlüssig verbindbar ist. Die Abmessungen der Ausnehmungen AN2 - AN5 und des aufzunehmenden Anschlussmoduls AM1 sind dabei derart geometrisch aufeinander abgestimmt, dass das Anschlussmodul AM1 nach Einführung in die Ausnehmung AN2 - AN5 bündig, d.h. formschlüssig mit der jeweiligen Stirnfläche 6, 7 im Bereich der Ausnehmung AN2 - AN5 abschliesst.

Für das Einsetzen des Anschlussmoduls AM1 wird vorteilhafter weise eine Nut-/Wulst-Verbindung verwendet, wobei die Stirnflächen 6, 7 der Ränder 4, 5 der Gehäuseteile 2, 3 im Bereich der Ausnehmung AN2 - AN5 jeweils eine umlaufende Wulst W3 bilden und wobei das Anschlussmodul AM1 zum Einsetzen in die Ausnehmung AN2 - AN5 eine umlaufende Nut N1 zum formschlüssigen Aufnehmen der Wulst W3 aufweist, wobei die Nut N1 durch eine erste Rippe R1 und eine zweite Rippe R2 gebildet wird, wobei nach dem Einsetzen des Anschlussmoduls AM1 und dem Zusammenfügen der beiden Gehäuseteile 2, 3 die erste Rippe R1 an einen Gehäuseinnenraum grenzt und die zweite Rippe R2 am Gehäuse gegen außen anliegt.

Die Wulst W3 und die Nut N1 können noch zusätzliche Dichtungselemente aufweisen, um sicherzustellen, dass Schmutz und Spritzwasser nicht in das Gehäuse gelangen können. So ist es z.B. möglich, dass die Wulst W3 und die Nut N1 wiederum selbst zu einander komplementäre Elemente für eine Nut-Wulst-Verbindung aufweisen, um die Dichtheit zu erhöhen. Mit Vorteil stellt eine solche weitere Nut-Wulst-Verbindung wiederum eine formschlüssige Verbindung her.

Eine Nut-/Wulst-Verbindung kann durch zusätzlich angebrachte Elemente an den Gehäuseteilen 2, 3 und/oder am Anschlussmodul AM1 bewerkstelligt werden. Mit Vorteil wird für eine Nut-/Wulst-Verbindung aber eine bereits vorhandene Geometrie der Gehäuseteile 2, 3 und/oder des Anschlussmoduls AM1 verwendet.

In der Darstellung gemäß Figur 4 wird die zweite Rippe R2 durch einen geometrisch passenden Teil des Anschlussmoduls AM1 gebildet.

Stellantriebe mit durch das Anschlussmodul AM1 zugeführten fest installierten Kabeln K1 weisen niedrige Herstellungskosten auf. Das Anschlussmodul AM1 wirkt dabei wie ein Klemmenblock oder Anschlussblock im Gehäuse. Ein oder mehrere Kabel K1 können dabei durch Löcher im Anschlussmodul dem Stellantrieb zugeführt sein. Diese Löcher nehmen das Kabel K1 formschlüssig auf, damit keine Verschmutzung in das Gehäuseinnere gelangt. Das Anschlussmodul AM1 besteht vorteilhafterweise aus einem Kunststoff (z.B. eine Gummiverbindung), der nach der Montage des Anschlussmoduls AM1 mit dem Gehäuse und den Kabeln formschlüssig verbunden ist, z.B. durch eine Pressverbindung. Der elektrische Anschlusskontakt kann z.B. durch einen AMP-Stecker erfolgen. Mit Vorteil weist das Kabel K1 wenigstens drei Adern auf.

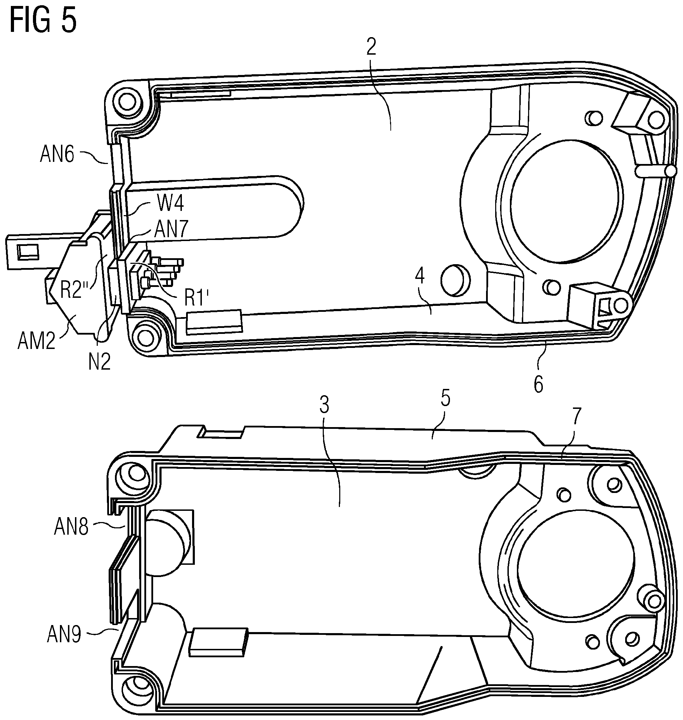

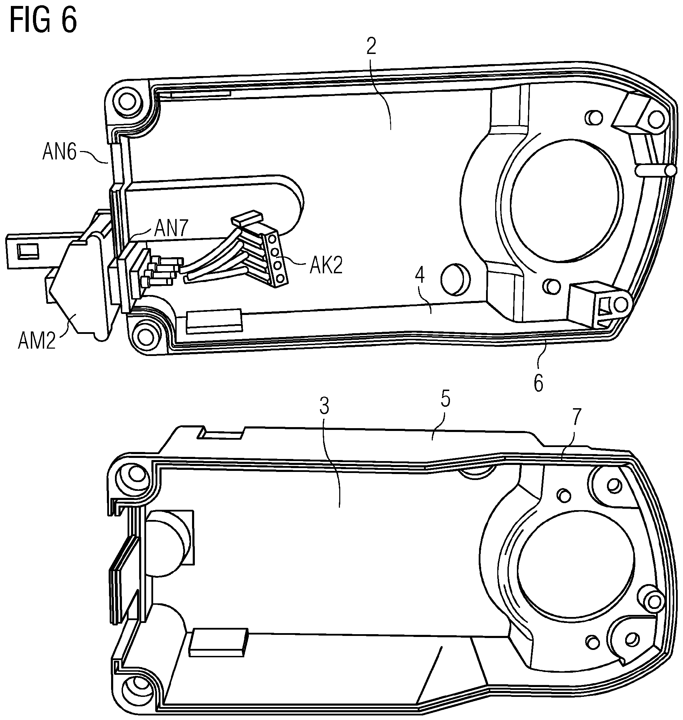

Figur 5 und Figur 6 zeigen jeweils Gehäuseteile 2, 3 mit einem zweiten beispielhaften Anschlussmodul AM2, AM2'.

Figur 5 zeigt Gehäuseteile 2, 3 mit einem zweiten beispielhaften Anschlussmodul AM2. In Figur 5 sind die Gehäuseteile 2, 3 einzeln (d.h. aufgeklappt bzw. offen) und nicht zu einem Gehäuse zusammen gesetzt dargestellt. Um ein zusammen gesetztes Gehäuse zu erreichen, müssten die Gehäuseteile 2 und 3 (wie schon in Figur 4 beschrieben) an den Stirnflächen 6, 7 im gegenseitigen Anschlag formschlüssig mit einander verbunden werden. Die Gehäuseteile 2, 3 weisen jeweils an ihren Ecken Ausnehmungen (Löcher) für Schraubverbindungen auf. In der Darstellung gemäß Figur 5 weisen die Gehäuseteile 2, 3 jeweils auf der rechten Seite eine runde Ausnehmung auf, für die Aufnahme der Achse zum Betätigen eines Stellglieds (z.B. eine Lüfterklappe oder Brandschutzklappe).

In der Darstellung gemäß Figur 5 weist das Gehäuseteil 2 zwei Ausnehmungen AN6, AN7 auf und das Gehäuseteil 3 die dazugehörigen Ausnehmungen AN8 und AN9 auf. Im zusammen gesetzten Zustand der Gehäuseteile 2, 3 bilden jeweils die Ausnehmungen AN6 und AN9, bzw. die Ausnehmungen AN7 und AN8 jeweils eine Zuführöffnung für das Anschlussmodul AM2. Eine zweite oder dritte Zuführöffnung für weitere Anschlussmodule AM2 ist optional. Es können bei einem Stellglied auch unterschiedliche Typen von Anschlussmodulen verwendet werden. Es ist nicht notwendig, dass jedes der Gehäuseteile 2, 3 Ausnehmungen AN6 - AN9 enthält. Eines der beiden Gehäuseteile 2, 3 kann z.B. nur als Deckel, d.h. ohne Ausnehmungen AN6 - AN9 ausgebildet sein. Mit Vorteil ist der Deckel so ausgebildet, dass eine formschlüssige und dichte Verbindung mit dem Anschlussmodul sichergestellt ist.

In der Darstellung gemäß Figur 5 ist beispielhafterweise das Anschlussmodul AM2 als einsetzbares Terminal mit einer Reihe von Anschlusskontakten zum Anschliessen elektrischer Komponenten im Gehäuse ausgestaltet. Das Anschlussmodul AM2 übernimmt dabei eine einfache Terminalfunktion, z.B. als fix eingesetztes Terminal mit Schutzklappe. Mit Vorteil sind die Anschlusskontakte des Anschlussmoduls AM2 durch eine daisy-chain-Verbindung gekoppelt. Daisy-chain-Verbindungen sind leicht und kostengünstig herstellbar und insbesonders für sogenannte "low-cost"-Märkte geeignet.

Auch Figur 6 zeigt ein beispielhaftes Anschlussmodul AM2', ausgebildet als einsetzbares Terminal mit einer Reihe von Anschlusskontakten zum Anschliessen elektrischer Komponenten in einem Stellantrieb. In der Darstellung gemäß Figur 6 ist das beispielhafte Anschlussmodul AM2' mit einer beispielhaften elektrischen Anschlusskontaktierung AK2 ausgestattet.

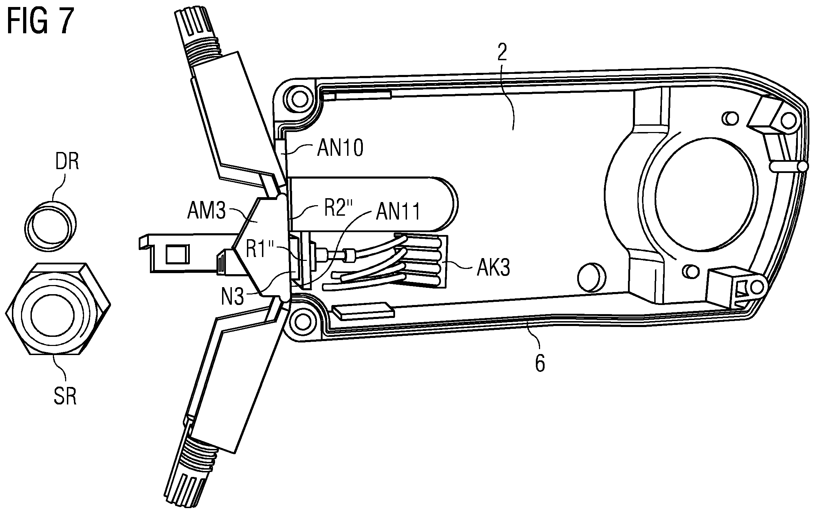

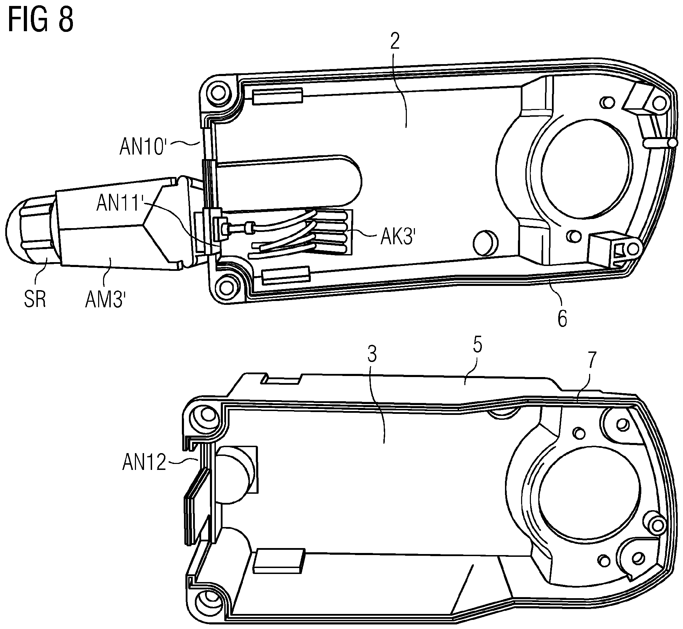

Figur 7 und Figur 8 zeigen jeweils Gehäuseteile 2, 3 mit einem dritten beispielhaften Anschlussmodul AM3 bzw. AM3'.

Figur 7 zeigt Gehäuseteil 2 mit einem dritten beispielhaften Anschlussmodul AM3. In Figur 7 bzw. in Figur 8 sind die Gehäuseteile 2, 3 einzeln (d.h. aufgeklappt bzw. offen) und nicht zu einem Gehäuse zusammengesetzt dargestellt. Um ein zusammengesetztes Gehäuse zu erreichen, müssten die Gehäuseteile 2 und 3 (wie schon in den Figuren 4 und 5 beschrieben) an den Stirnflächen 6, 7 im gegenseitigen Anschlag formschlüssig mit einander verbunden werden. Die Gehäuseteile 2, 3 weisen jeweils an ihren Ecken Ausnehmungen (Löcher) für Schraubverbindungen auf. In Figur 7 weisen die Gehäuseteile 2, 3 jeweils auf der rechten Seite eine runde Ausnehmung auf, für die Aufnahme der Achse zum Betätigen eines Stellglieds (z.B. eine Lüfterklappe oder Brandschutzklappe).

In der Darstellung gemäß Figur 7 weist das Gehäuseteil 2 zwei Ausnehmungen AN10, AN11 auf, jeweils zur Zuführung eines Anschlussmoduls. In Figur 7 ist beispielhafter weise das Anschlussmodul AM3 als einsetzbares Schraubterminal, insbesondere für die Schutzklasse IP 54, ausgebildet ist. Das Anschlussmodul übernimmt dabei eine Terminalfunktion, z.B. als fix eingesetztes Schraubterminal mit Schutzklappe.

In der Darstellung gemäß Figur 7 ist ein einsetzbares Schraubterminal mit zwei aufgeklappten Flügelhälften dargestellt. Um ein Kabel im Schraubterminal AM3 zu befestigen, wird ein Kabel eingelegt, mit den Anschlüssen des Terminals verbunden, die Flügelhälften zusammen geklappt und durch die Schraube SR, in die das Kabel einfädelbar ist, werden die beiden Flügelhälften durch eine Schraubverbindung verbunden. Mit Vorteil wird bei der Schraubverbindung ein Dichtring DR verwendet, um das Eindringen von Schmutz in das Anschlussmodul AM3 zu verhindern. Durch elektrische Anschlusskontakte AK3 erfolgt die Kontaktierung zu den elektrischen Komponenten im Stellantrieb. In Figur 7 ist nur ein Gehäuseteil 2 sichtbar. Bei dem Schraubterminal kann es sich z.B. um eine PG-Verschraubung oder eine Conduit-Verschraubung handeln.

Für das Einsetzen des Anschlussmoduls AM3 wird vorteilhafter weise wieder eine Nut-/Wulst-Verbindung verwendet, wobei die Stirnflächen der Ränder der Gehäuseteile im Bereich der Ausnehmung AN10, AN11 jeweils eine umlaufende Wulst bilden und wobei das Anschlussmodul AM3 zum Einsetzen in die Ausnehmung AN10, AN11 eine umlaufende Nut N3 zum formschlüssigen Aufnehmen der Wulst aufweist, wobei die Nut N3 durch eine erste Rippe R1" und eine zweite Rippe R2" gebildet wird, wobei nach dem Einsetzen des Anschlussmoduls AM3 und dem Zusammenfügen der beiden Gehäuseteile die erste Rippe R1" an einen Gehäuseinnenraum grenzt und die zweite Rippe R2" am Gehäuse gegen außen anliegt.

Eine Nut-/Wulst-Verbindung kann durch zusätzlich angebrachte Elemente an den Gehäuseteilen 2 und/oder am Anschlussmodul AM3 bewerkstelligt werden. Mit Vorteil wird für eine Nut-/Wulst-Verbindung aber eine bereits vorhandene Geometrie eines Gehäuseteils 2 und/oder des Anschlussmoduls AM3 verwendet. In der Darstellung gemäß Figur 7 wird die zweite Rippe R2" durch eine geometrisch angepasste Fläche des Anschlussmoduls AM3 gebildet.

In Figur 8 ist beispielhafter weise das als einsetzbares Schraubterminal ausgebildete Anschlussmodul AM3' im geschlossenen Zustand dargestellt. D.h. in der Darstellung gemäß Figur 8 sind die beiden Flügelhälften des Schraubterminals AM3' durch eine Schraube SR formschlüssig verbunden.

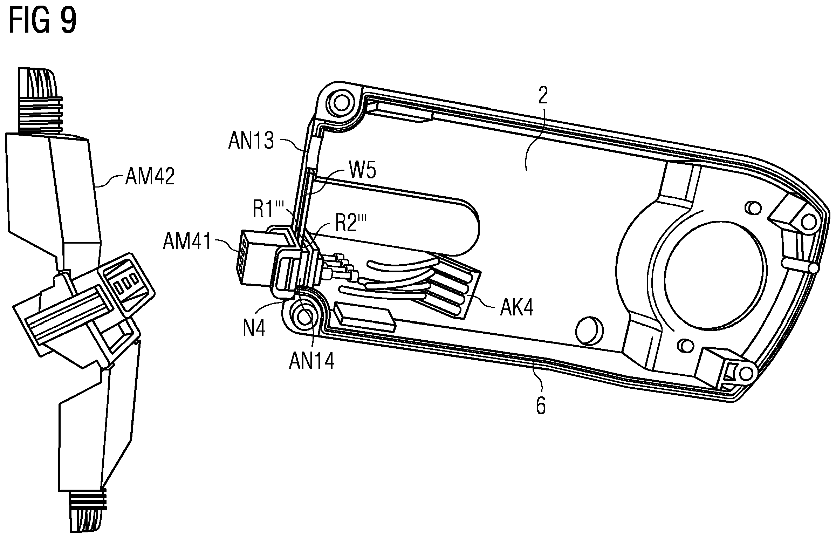

Die Figuren 9 bis 11 zeigen jeweils Gehäuseteile 2 bzw. Stellantriebe 1 mit einem vierten beispielhaften Anschlussmodul AM41, AM41', AM41" , AM42, AM42', AM42", wobei das Anschlussmodul zweiteilig ausgebildet ist, wobei der erste Teil AM41, AM41', AM41" im Bereich der Ausnehmung AN13, AN14 formschlüssig in das Gehäuse einsetzbar ist und am Gehäuseaußenteil eine Buchse für eine Steckverbindung aufweist, und wobei der zweite Teil AM42, AM42', AM42" als steckbares Schraubterminal mit einer zur Buchse komplementären Gegensteckverbindung ausgebildet ist. Mit Vorteil wird dabei der erste Teil AM41, AM41', AM41" des Anschlussmoduls durch eine Nut-/Wulst-Verbindung mit dem Gehäuse des Stellantriebs 1 formschlüssig verbunden.

Die Darstellung in Figur 9 zeigt, wie der erste Teil AM41, AM41', AM41" des Anschlussmoduls durch eine Nut-/Wulst-Verbindung in das Gehäuseteil 2 einsetzbar ist.

Dabei bilden die Stirnflächen der Ränder der Gehäuseteile im Bereich der Ausnehmung AN13 bzw. AN14 jeweils eine umlaufende Wulst und der erste Teil AM41, AM41', AM41" des Anschlussmoduls bildet zum Einsetzen in die Ausnehmung AN13 bzw. AN14 eine umlaufende Nut N4 zum formschlüssigen Aufnehmen der Wulst. In Figur 9 wird die Nut N4 durch eine erste Rippe R1"' und eine zweite Rippe R2"' gebildet, wobei nach dem Einsetzen des ersten Teils AM41, AM41', AM41" des Anschlussmoduls und dem Zusammenfügen der beiden Gehäuseteile die erste Rippe R1"' an einen Gehäuseinnenraum grenzt und die zweite Rippe R2"' am Gehäuse gegen außen anliegt.

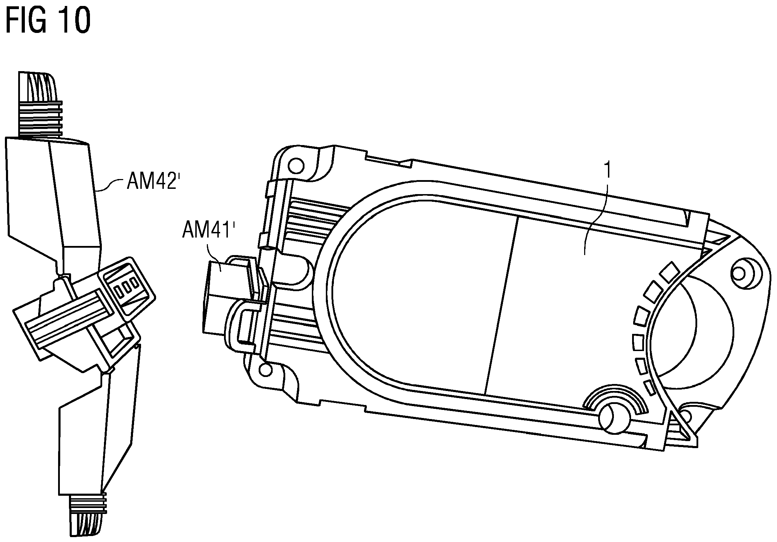

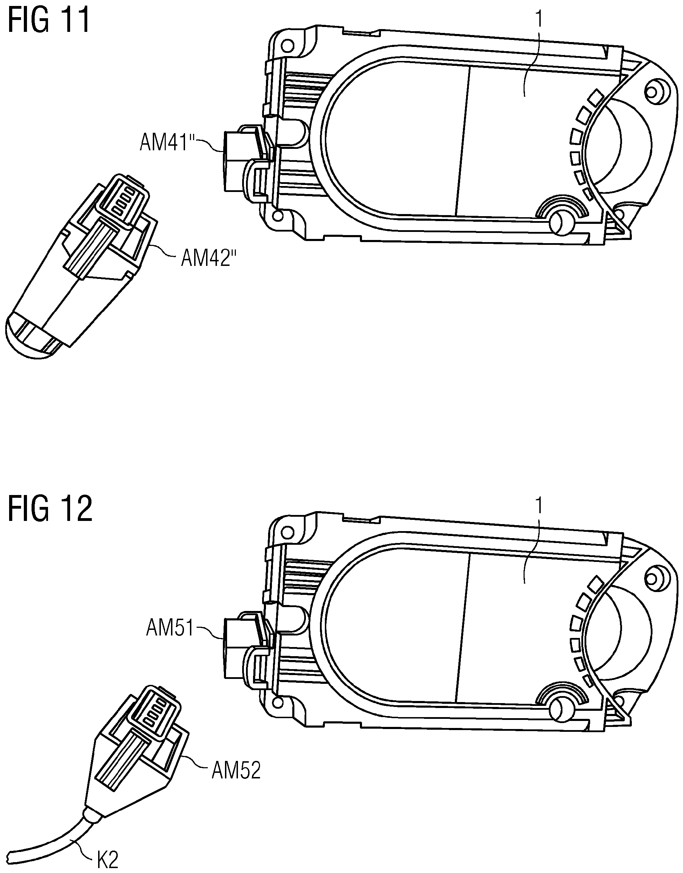

Eine Nut-/Wulst-Verbindung kann durch zusätzlich angebrachte Elemente an den Gehäuseteilen 2 und/oder am ersten Teil AM41, AM41', AM41" des Anschlussmoduls bewerkstelligt werden. Mit Vorteil wird für eine Nut-/Wulst-Verbindung aber eine bereits vorhandene Geometrie eines Gehäuseteils 2 und/oder des ersten Teils AM41, AM41', AM41" des Anschlussmoduls verwendet. In der Darstellung gemäß Figur 9 wird die zweite Rippe R2"' durch einen entsprechend ausgestalteten Teil des ersten Teils AM41, AM41', AM41" (Figuren 10, 11) des Anschlussmoduls gebildet.

Das Anschlussmodul gemäß Darstellung in Figur 9 wirkt somit, wie ein ein- und aussteckbarer Netzstecker. In Figur 9 ist der zweite Teil AM42 des Anschlussmoduls als steckbares Schraubterminal mit geöffneten Flügelhälften dargestellt.

Figur 10 zeigt ein Stellglied 1, mit zusammengefügten Gehäuseteilen. Auch in Figur 10 ist der zweite Teil AM42' des Anschlussmoduls als steckbares Schraubterminal mit geöffneten Flügelhälften dargestellt. Im Stellglied 1 ist die zum steckbaren Schraubterminal AM42' komplementäre Gegensteckverbindung AM41' formschlüssig, z.B. durch eine Nut-/Wulst-Verbindung formschlüssig eingebracht.

Auch Figur 11 zeigt ein Stellglied 1, mit zusammengefügten Gehäuseteilen. In Figur 11 ist aber der zweite Teil AM42" des Anschlussmoduls als steckbares Schraubterminal mit geschlossenen Flügelhälften dargestellt. Auch in der Darstellung gemäß Figur 11 ist im Stellglied 1 die zum steckbaren Schraubterminal AM42" komplementäre Gegensteckverbindung AM41" formschlüssig und festsitzend befestigt.

Das steckbare Schraubterminal wie in den Figuren 9 bis 11 dargestellt, kann unabhängig vom mechanisch vormontierten Stellantrieb an geeigneter Stelle verdrahtet werden. Stellantriebe werden oft an schwer zugänglichen Stellen wie Zwischendecken mechanisch vormontiert und erst zu einem späteren Zeitpunkt elektrisch verdrahtet. Weiterhin ist eine gute Zugänglichkeit zu den Schraubterminals gewährleistet, insbesondere bei wendbaren Federrücklauf-Stellantrieben in beiden möglichen Montagepositionen. Bei einem entsprechend mechanisch vormontierten Stellantrieb ist somit eine vereinfachte 2-Hand-Montage (Draht / Schraubenzieher) möglich. Weiterhin kann der Stellantrieb ausgewechselt werden ohne vorgängige elektrische Abschaltung. Diverse Warnhinweise in der Montageanleitung oder auf dem Gehäuse können somit entfallen.

Figur 12 zeigt einen Stellantrieb 1 mit einem fünften beispielhaften, zweiteilig ausgebildeten, Anschlussmodul AM51, AM52, wobei der erste Teil AM51 im Bereich der Ausnehmung formschlüssig in das Gehäuse einsetzbar ist und am Gehäuseaußenteil eine Buchse für eine Steckverbindung aufweist, und wobei der zweite Teil AM52 als steckbares Terminal mit einer zur Buchse komplementären Gegensteckverbindung ausgebildet ist, wobei das Terminal durch einen elektrisch isolierten Kunststoff an ein zugeführtes Kabel gespritzt ist. Das zugeführte Kabel muss somit nicht mit einer Klemmverbindung oder Schraubverbindung am Terminal befestigt werden. Das steckbare Terminal AM52 mit dem zuzuführenden Kabel K2 kann z.B. im Spritzgussverfahren aus einem elektrisch isolierenden Kunststoff, beispielweise ABS hergestellt werden. Auch die Ausführung gemäß Figur 12 ermöglicht, dass der Stellantrieb ausgewechselt werden kann ohne vorgängige elektrische Abschaltung. Diverse Warnhinweise in der Montageanleitung oder auf dem Gehäuse können somit auch bei dieser Ausgestaltung entfallen.

Eine weitere vorteilhafte Ausgestaltung der Erfindung liegt darin, dass der Stellantrieb einen Schaltungsträger (z.B. Platine, Leiterplatte) mit Kontaktelementen umfasst, wobei die Kontaktelemente ausgebildet sind mit dazu komplementären Kontaktelementen des Anschlussmoduls beim Einsetzen des Anschlussmoduls eine elektrische Kontaktierung zu ermöglichen. Dadurch wird für die elektrische Kontaktierung ein Arbeitsschritt eingespart. Die elektrische Kontaktierung erfolgt automatisch durch das Einsetzen des Anschlussmoduls durch die physikalische Kontaktierung der Kontaktelemente. Das Einsetzen und die Kontaktierung erfolgen somit in einem gemeinsamen Arbeitsgang. Dies ist insbesondere vorteilhaft bei einer Montage vor Ort (z.B. auf der Baustelle).

Die erfindungsgemäßen Stellantriebe und Anschlussmodule ermöglichen eine flexible und effiziente elektrische Installation und damit einen Wettbewerbsvorteil. Weiterhin lassen sich damit alle in der Branche geforderten elektrischen Anschlussschnittstellen abdecken. Auch ist es leicht möglich Anschlussschnittstellen auszutauschen oder aufzurüsten. Eine Skalierung der Stellantriebe hinsichtlich der Anschlussschnittstellen ist somit möglich. Da in ein Stellglied unterschiedliche Anschlussschnittstellen einsetzbar sind, können die Stellglieder kostenoptimaler gefertigt werden (economies of scale).

Stellantrieb mit einem Gehäuse, welches ein erstes Gehäuseteil und ein zweites Gehäuseteil aufweist, wobei die beiden Gehäuseteile je einen Rand mit je einer Stirnfläche aufweisen und wobei beim Zusammenfügen der beiden Gehäuseteile die beiden Stirnflächen sich gegenüberliegen, wobei das erste Gehäuseteil und das zweite Gehäuseteil lösbar und direkt oder mit einer Dichtung zusammenfügbar sind, wobei der Stellantrieb ausgebildet ist, ein wechselbares Anschlussmodul für eine Kabelzuführung aufzunehmen, wobei das wechselbares Anschlussmodul in einer Ausnehmung des ersten Randes des ersten Gehäuseteils einsetzbar ist und wobei beim Zusammenfügen der beiden Gehäuseteile das wechselbare Anschlussmodul mit den Stirnflächen der Ränder in einem Bereich der Ausnehmung formschlüssig verbindbar ist. Es wird somit ein Stellantrieb, insbesondere für Lüftungs- oder Brandschutzklappen, bereitgestellt, mit einer hohen Flexibilität in der elektrischen Anschlusskontaktierung.

## Patentansprüche

1. Stellantrieb (1) mit einem Gehäuse (GH), welches ein erstes Gehäuseteil (2) und ein zweites Gehäuseteil (3) aufweist, wobei die beiden Gehäuseteile (2,3) je einen Rand (4,5) mit je einer Stirnfläche (6,7) aufweisen und wobei beim Zusammenfügen der beiden Gehäuseteile (2,3) die beiden Stirnflächen (6,7) sich gegenüberliegen, wobei das erste Gehäuseteil (2) und das zweite Gehäuseteil (3) lösbar zusammenfügbar sind, der Stellantrieb (1) ausgebildet ist, ein wechselbares Anschlussmodul (AM1-AM3, AM2'-AM3', AM41,AM41',AM41",AM51, AM42,AM42',AM42",AM52) für eine Kabelzuführung aufzunehmen, wobei das wechselbares Anschlussmodul (AM1-AM3, AM2'-AM3', AM41,AM41',AM41",AM51, AM42,AM42',AM42'',AM52) in einer Ausnehmung (AN1-AN11, AN6'-AN9') des ersten Randes (4) des ersten Gehäuseteils (2) einsetzbar ist und wobei beim Zusammenfügen der beiden Gehäuseteile (2,3) das wechselbare Anschlussmodul (AM1-AM3, AM2'-AM3', AM41,AM41',AM41",AM51, AM42,AM42',AM42",AM52) mit den Stirnflächen (6,7) der Ränder (4,5) in einem Bereich der Ausnehmung (AN1-AN14, AN6',AN7', AN10', AN11') formschlüssig verbindbar ist, **dadurch gekennzeichnet, dass** das Anschlussmodul (AM1-AM3, AM2'-AM3',AM41,AM41',AM41",AM51, AM42,AM42',AM42",AM52) für die elektrische Stromversorgung unterschiedlich ausgebildet sein kann, wobei auch das zweite Gehäuseteil (3) eine Ausnehmung (AN4, AN5, AN8, AN9, AN12) des zweiten Randes (5), zur zusammen mit der Ausnehmung (AN1, AN2, AN3, AN6, AN7, AN6',AN7', AN19, AN11, AN13, AN14) des ersten Randes (4) zusammenwirkenden Aufnahme des Anschlussmoduls (AM1-AM3, AM2'-AM3', AM41, AM41', AM41" , AM51, AM42, AM42', AM42", AM52), aufweist.

2. Stellantrieb (1) nach Anspruch 1, wobei für das Einsetzen des Anschlussmoduls (AM1-AM3, AM2'-AM3', AM41,AM41', AM41" , AM51, AM42, AM42',AM42",AM52) eine Nut-/Wulst-Verbindung verwendet wird, wobei die Stirnflächen (6, 7) der Ränder (4, 5) im Bereich der Ausnehmung (AN1-AN14, AN6',AN7', AN10', AN11') eine umlaufende Wulst bilden und wobei das Anschlussmodul (AM1-AM3, AM2'-AM3', AM41,AM41',AM41'',AM51, AM42, AM42', AM42'', AM52) zum Einsetzen in die Ausnehmung eine umlaufende Nut zum formschlüssigen Aufnehmen der Wulst aufweist, wobei die Nut durch eine erste Rippe und eine zweite Rippe gebildet wird, wobei nach dem Einsetzen des Anschlussmoduls (AM1-AM3, AM2'-AM3', AM41, AM41', AM41" , AM51, AM42, AM42', AM42'', AM52) und dem Zusammenfügen der beiden Gehäuseteile (2,3) die erste Rippe an einen Gehäuseinnenraum grenzt und die zweite Rippe am Gehäuse (GH) gegen außen anliegt.

3. Stellantrieb (1) nach Anspruch 2, wobei die zweite Rippe durch einen Körper des Anschlussmoduls (AM1-AM3, AM2'-AM3', AM41, AM41', AM41" , AM51, AM42, AM42', AM42", AM52) gebildet wird.

4. Stellantrieb (1) nach einem der vorherigen Ansprüche, wobei der Stellantrieb (1) ausgebildet ist, mehrere Anschlussmodule (AM1-AM3, AM2'-AM3, AM41, AM41', AM41" , AM51, AM42, AM42', AM42'', AM52) aufzunehmen.

5. Stellantrieb (1) nach einem der vorherigen Ansprüche, wobei durch das Anschlussmodul (AM1-AM3, AM2'-AM3', AM41, AM41', AM41" , AM51, AM42, AM42', AM42", AM52) ein im Stellantrieb fest installiertes Kabel (K1) zugeführt wird.

6. Stellantrieb (1) nach einem der vorherigen Ansprüche, wobei das Anschlussmodul (AM1-AM3, AM2'-AM3', AM41, AM41', AM41" , AM51, AM42, AM42', AM42" , AM52) als einsetzbares Terminal mit einer Reihe von Anschlusskontakten (AK1-AK4, AK3') zum Anschliessen elektrischer Komponenten im Gehäuse (GH) ausgestaltet ist.

7. Stellantrieb (1) nach Anspruch 6, wobei die Anschlusskontakte (AK1-AK4, AK3') durch eine daisy-chain-Verbindung gekoppelt sind.

8. Stellantrieb (1) nach einem der vorherigen Ansprüche, wobei das Anschlussmodul (AM1-AM3, AM2'-AM3', AM41, AM41', AM41" , AM51, AM42, AM42', AM42" , AM52) als einsetzbares Schraubterminal, insbesondere für die Schutzklasse IP 54, ausgebildet ist.

9. Stellantrieb (1) nach einem der vorherigen Ansprüche, wobei das Anschlussmodul (AM1-AM3, AM2'-AM3', AM41, AM41', AM41'', AM51, AM42, AM42', AM42'', AM52) zweiteilig ausgebildet ist, wobei der erste Teil (AM41, AM41', AM41'', AM51) im Bereich der Ausnehmung (AN1-AN14, AN6',AN7', AN10', AN11') formschlüssig in das Gehäuse (GH) einsetzbar ist und am Gehäuseaußenteil eine Buchse für eine Steckverbindung aufweist, und wobei der zweite Teil (AM42, AM42', AM42" , AM52) als steckbares Schraubterminal mit einer zur Buchse komplementären Gegensteckverbindung ausgebildet ist.

10. Stellantrieb (1) nach einem der vorherigen Ansprüche, wobei das Anschlussmodul (AM1-AM3, AM2'-AM3', AM41, AM41', AM41'', AM51, AM42, AM42', AM42'', AM52) zweiteilig ausgebildet ist, wobei der erste Teil im Bereich der Ausnehmung (AN1-AN14, AN6',AN7', AN10', AN11') formschlüssig in das Gehäuse (GH) einsetzbar ist und am Gehäuseaußenteil eine Buchse für eine Steckverbindung aufweist, und wobei der zweite Teil als steckbares Terminal mit einer zur Buchse komplementären Gegensteckverbindung ausgebildet ist, wobei das Terminal durch einen elektrisch isolierten Kunststoff an ein zugeführtes Kabel (K1, K2) gespritzt ist.

11. Stellantrieb (1) nach einem der vorherigen Ansprüche, wobei der Stellantrieb (1) einen Schaltungsträger mit Kontaktelementen umfasst, wobei die Kontaktelemente ausgebildet sind mit dazu komplementären Kontaktelementen des Anschlussmoduls (AM1-AM3, AM2'-AM3', AM41, AM41', AM41", AM51, AM42, AM42', AM42'', AM52) beim Einsetzen des Anschlussmoduls (AM1-AM3, AM2'-AM3', AM41, AM41', AM41", AM51, AM42, AM42', AM42", AM52) eine elektrische Kontaktierung zu ermöglichen.

12. Stellantrieb (1) nach Anspruch 1, wobei für das Einsetzen des Anschlussmoduls (AM1-AM3, AM2'-AM3', AM41, AM41', AM41", AM51, AM42, AM42', AM42" , AM52) eine Nut-/Wulst-Verbindung verwendet wird, wobei die Stirnflächen der Ränder im Bereich der Ausnehmung (AN1-AN14, AN6',AN7', AN10', AN11') eine umlaufende Nut bilden und wobei das Anschlussmodul (AM1-AM3, AM2'-AM3', AM41, AM41', AM41", AM51, AM42, AM42', AM42", AM52) zum Einsetzen in die Ausnehmung eine umlaufende Wulst zum formschlüssigen Einsetzen in die Nut aufweist, wobei die Nut durch eine erste Rippe und eine zweite Rippe gebildet wird, wobei die erste Rippe an einem Gehäuseinnenraum anliegt und die zweite Rippe an einem Gehäuseaussenraum.

13. Anschlussmodul (AM1-AM3, AM2'-AM3', AM41, AM41', AM41", AM51, AM42, AM42', AM42", AM52) für eine Kabelzuführung zu einem Stellantrieb (1) nach einem der Ansprüche 1 bis 12, wobei das Anschlussmodul (AM1-AM3, AM2'-AM3', AM41, AM41', AM41'', AM51, AM42, AM42', AM42'', AM52) in einer Ausnehmung eines Randes eines Gehäuseteil (2, 3) einsetzbar ist und wobei beim Zusammenfügen der beiden Gehäuseteile (2, 3) das Anschlussmodul (AM1-AM3, AM2'-AM3', AM41, AM41', AM41", AM51, AM42, AM42', AM42'', AM52) mit den Stirnflächen (6, 7) der Ränder (4, 5) in einem Bereich der Ausnehmung (AN1-AN14, AN6',AN7', AN10', AN11') formschlüssig verbindbar ist, wobei das Anschlussmodul (AM1-AM3, AM2'- AM3', AM41, AM41', AM41",AM51, AM42, AM42', AM42'', AM52) für die elektrische Stromversorgung unterschiedlich ausgebildet sein kann.

14. Anordnung für den Antrieb von Stellgliedern, die Anordnung umfassend:
einen Stellantrieb (1) nach einem der Ansprüche 1 bis 12, mit einem Gehäuse (GH), welches ein erstes Gehäuseteil (2) und ein zweites Gehäuseteil (3) aufweist, wobei die beiden Gehäuseteile (2, 3) je einen Rand (4, 5) mit je einer Stirnfläche (6, 7) aufweisen und wobei beim Zusammenfügen der beiden Gehäuseteile (2, 3) die beiden Stirnflächen (6, 7) sich gegenüberliegen, wobei das erste Gehäuseteil (2) und das zweite Gehäuseteil (3) lösbar zusammenfügbar sind, und
ein Anschlussmodul (AM1-AM3, AM2'-AM3', AM41, AM41', AM41'', AM51, AM42, AM42', AM42'', AM52) für eine Kabelzuführung zum Stellantrieb, wobei das Anschlussmodul (AM1-AM3, AM2'-AM3', AM41, AM41', AM41", AM51, AM42, AM42', AM42", AM52) in einer Ausnehmung des ersten Randes (4) des ersten Gehäuseteils (2) eingesetzt ist und wobei durch ein Zusammenfügen der beiden Gehäuseteile (2, 3) das wechselbare Anschlussmodul (AM1-AM3, AM2'-AM3', AM41, AM41', AM41", AM51, AM42, AM42', AM42'', AM52) mit den Stirnflächen (6, 7) der Ränder (4, 5) in einem Bereich der Ausnehmung (AN1-AN14, AN6',AN7', AN10', AN11') formschlüssig verbunden ist, wobei das Anschlussmodul (AM1-AM3, AM2'- AM3', AM41, AM41', AM41",AM51, AM42, AM42', AM42'', AM52) für die elektrische Stromversorgung unterschiedlich ausgebildet sein kann.

15. Anordnung nach Anspruch 14, wobei es sich beim Anschlussmodul (AM1-AM3, AM2'-AM3', AM41, AM41', AM41", AM51, AM42, AM42', AM42'', AM52) um ein Anschlussmodul (AM1-AM3, AM2'-AM3', AM41, AM41', AM41", AM51, AM42, AM42', AM42", AM52) gemäß Anspruch 13 handelt.

## Claims

1. Actuating drive (1), comprising a housing (GH), which has a first housing part (2) and a second housing part (3), wherein the two housing parts (2, 3) each have an edge (4, 5), each edge having an end face (6, 7), and wherein the two end faces face each other when the two housing parts (2, 3) are joined, wherein the first housing part (2) and the second housing part (3) can be detachably joined, the actuating drive (1) is designed to accommodate an exchangeable connection module (AM1-AM3, AM2'-AM3', AM41, AM41', AM41", AM51, AM42, AM42', AM42'', AM52) for a cable feed, wherein the exchangeable connection module (AM1-AM3, AM2'-AM3', AM41, AM41', AM41", AM51, AM42, AM42', AM42", AM52) can be inserted into an opening (AN1-AN11, AN6'-AN9') of the first edge (4) of the first housing part (2) and wherein the exchangeable connection module (AM1-AM3, AM2'-AM3', AM41, AM41', AM41", AM51, AM42, AM42', AM42", AM52) can be connected in a form-fitting manner to the end faces (6, 7) of the edges (4, 5) in a region of the opening (AN1-AN14, AN6', AN7', AN10', AN11') when the two housing parts (2, 3) are joined,
**characterised in that**
the connection module (AM1-AM3, AM2'-AM3', AM41, AM41', AM41", AM51, AM42, AM42', AM42" , AM52) for the electrical power supply can have different designs, wherein the second housing part (3) also has an opening (AN4, AN5, AN8, AN9, AN12) of the second edge (5) for jointly accommodating the connection module (AM1-AM3, AM2'-AM3', AM41, AM41', AM41", AM51, AM42, AM42', AM42", AM52) together with the opening (AN1, AN2, AN3, AN6, AN7, AN6', AN7', AN19, AN11, AN13, AN14) of the first edge (4).

2. Actuating drive (1) according to claim 1, wherein a groove-bead connection is used for insertion of the connection module (AM1-AM3, AM2'-AM3', AM41, AM41', AM41", AM51, AM42, AM42', AM42'', AM52), wherein the end faces (6, 7) of the edges (4, 5) form a peripheral bead in the region of the opening (AN1-AN14, AN6', AN7', AN10', AN11') and wherein for insertion into the opening the connection module (AM1-AM3, AM2'-AM3', AM41, AM41', AM41", AM51, AM42, AM42', AM42", AM52) has a peripheral groove for accommodating the bead in a form-fitting manner, wherein the groove is formed by a first rib and a second rib, wherein, after insertion of the connection module (AM1-AM3, AM2'-AM3', AM41, AM41', AM41", AM51, AM42, AM42', AM42", AM52) and joining of the two housing parts (2, 3), the first rib borders a housing interior and the second rib rests on the housing (GH) to the outside.

3. Actuating drive (1) according to claim 2, wherein the second rib is formed by a body of the connection module (AM1-AM3, AM2'-AM3', AM41, AM41', AM41", AM51, AM42, AM42', AM42'', AM52).

4. Actuating drive (1) according to one of the preceding claims, wherein the actuating drive (1) is designed to accommodate a plurality of connection modules (AM1-AM3, AM2'-AM3', AM41, AM41', AM41" , AM51, AM42, AM42', AM42", AM52).

5. Actuating drive (1) according to one of the preceding claims, wherein a cable (K1) permanently installed in the actuating drive (1) is fed through the connection module (AM1-AM3, AM2'-AM3', AM41, AM41', AM41", AM51, AM42, AM42', AM42'', AM52).

6. Actuating drive (1) according to one of the preceding claims, wherein the connection module (AM1-AM3, AM2'-AM3', AM41, AM41', AM41", AM51, AM42, AM42', AM42", AM52) can be configured as an insertable terminal with a series of connecting contacts (AK1-AK4, AK3') for connecting electrical components in the housing (GH).

7. Actuating drive (1) according to claim 6, wherein the connecting contacts (AK1-AK4, AK3') are coupled by a daisy chain connection.

8. Actuating drive (1) according to one of the preceding claims, wherein the connection module (AM1-AM3, AM2'-AM3', AM41, AM41', AM41", AM51, AM42, AM42', AM42", AM52) is designed as an insertable screw terminal, in particular for protection category IP 54.

9. Actuating drive (1) according to one of the preceding claims, wherein the connection module (AM1-AM3, AM2'-AM3', AM41, AM41', AM41" , AM51, AM42, AM42', AM42", AM52) is designed in two parts, wherein the first part (AM41, AM41', AM41'', AM51) can be inserted into the housing (GH) in a form-fitting manner in the region of the opening (AN1-AN14, AN6', AN7', AN10', AN11') and has a socket for a plug-in connection on the housing outer part, and wherein the second part (AM42, AM42', AM42'', AM52) is designed as a pluggable screw terminal having a mating connector complementary with the socket.

10. Actuating drive (1) according to one of the preceding claims, wherein the connection module (AM1-AM3, AM2'-AM3', AM41, AM41', AM41", AM51, AM42, AM42', AM42", AM52) is designed in two parts, wherein the first part can be inserted into the housing in a form-fitting manner in the region of the opening (AN1-AN14, AN6', AN7', AN10', AN11') and has a socket for a plug-in connection on the housing outer part, and wherein the second part is designed as a pluggable terminal having a mating connector complementary with the socket, wherein the terminal is injected on to a fed cable (K1, K2) by way of an electrically insulated plastics material.

11. Actuating drive (1) according to one of the preceding claims, wherein the actuating drive (1) comprises a circuit carrier having contact elements, wherein the contact elements are designed with contact elements of the connection module (AM1-AM3, AM2'-AM3', AM41, AM41', AM41", AM51, AM42, AM42', AM42" , AM52) that are complementary therewith for enabling electrical contacting on insertion of the connection module (AM1-AM3, AM2'-AM3', AM41, AM41', AM41", AM51, AM42, AM42', AM42'', AM52).

12. Actuating drive (1) according to claim 1, wherein a groove-bead connection is used for insertion of the connection module (AM1-AM3, AM2'-AM3', AM41, AM41', AM41", AM51, AM42, AM42', AM42'', AM52), wherein the end faces of the edges form a peripheral groove in the region of the opening (AN1-AN14, AN6', AN7', AN10', AN11') and wherein, for insertion into the opening, the connection module (AM1-AM3, AM2'-AM3', AM41, AM41', AM41", AM51, AM42, AM42', AM42", AM52) has a peripheral bead for insertion in a form-fitting manner into the groove, wherein the groove is formed by a first rib and a second rib, wherein the first rib rests on a housing interior and the second rib on a housing exterior.

13. Connection module (AM1-AM3, AM2'-AM3', AM41, AM41', AM41", AM51, AM42, AM42', AM42", AM52) for a cable feed to an actuating drive (1) according to one of claims 1 to 12, wherein the connection module (AM1-AM3, AM2'-AM3', AM41, AM41', AM41", AM51, AM42, AM42', AM42", AM52) can be inserted into an opening in an edge of a housing part (2, 3) and wherein the connection module (AM1-AM3, AM2'-AM3', AM41, AM41', AM41" , AM51, AM42, AM42', AM42", AM52) can be connected in a form-fitting manner to the end faces (6, 7) of the edges (4, 5) in a region of the opening (AN1-AN14, AN6', AN7', AN10', AN11') when the two housing parts (2, 3) are joined, wherein the connection module (AM1-AM3, AM2'-AM3', AM41, AM41', AM41", AM51, AM42, AM42', AM42", AM52) for the electrical power supply can have different designs.

14. Arrangement for the drive of actuators, the arrangement comprising:
an actuating drive (1) according to one of claims 1 to 12, comprising a housing (GH), which has a first housing part (2) and a second housing part (3), wherein the two housing parts (2, 3) each have an edge (4, 5), each edge having an end face (6, 7), and wherein the two end faces (6, 7) face each other when the two housing parts (2, 3) are joined, wherein the first housing part (2) and the second housing part (3) can be detachably joined,
and a connection module (AM1-AM3, AM2'-AM3', AM41, AM41', AM41", AM51, AM42, AM42', AM42", AM52) for a cable feed to the actuating drive, wherein the connection module (AM1-AM3, AM2'-AM3', AM41, AM41', AM41", AM51, AM42, AM42', AM42" , AM52) is inserted into an opening of the first edge (4) of the first housing part (2) and wherein the exchangeable connection module (AM1-AM3, AM2'-AM3', AM41, AM41', AM41", AM51, AM42, AM42', AM42'', AM52) can be connected in a form-fitting manner to the end faces (6, 7) of the edges (4, 5) in a region of the opening (AN1-AN14, AN6', AN7', AN10', AN11') by joining the two housing parts (2, 3), wherein the connection module (AM1-AM3, AM2'-AM3', AM41, AM41', AM41", AM51, AM42, AM42', AM42" , AM52) for the electrical power supply can have different designs.

15. Arrangement according to claim 14, wherein the connection module (AM1-AM3, AM2'-AM3', AM41, AM41', AM41", AM51, AM42, AM42', AM42'', AM52) is a connection module (AM1-AM3, AM2'-AM3', AM41, AM41', AM41", AM51, AM42, AM42', AM42", AM52) according to claim 13.

## Revendications

1. Actionneur (1) comportant un boîtier (GH) présentant une première partie de boîtier (2) et une seconde partie de boîtier (3), les deux parties de boîtier (2, 3) comportant chacune un bord (4, 5) pourvu chacun d'une face frontale (6, 7), et lors de l'assemblage des deux parties de boîtier (2, 3), les deux faces frontales (6,7) étant disposées face à face, et la première et la seconde partie de boîtier (2, 3) pouvant être assemblées de manière amovible, et
l'actionneur étant conçu pour recevoir un module de raccordement interchangeable (AM1-AM3, AM2'-AM3', AM41, AM41', AM41", AM51, AM42, AM42', AM42", AM52) pour une amenée de câble, ledit module de raccordement interchangeable (AM1-AM3, AM2'-AM3', AM41, AM41', AM41", AM51, AM42, AM42', AM42'', AM52) pouvant être introduit dans un évidement (AN1-AN11, AN6'-AN9') du premier bord (4) de la première partie de boîtier (2) et dans lequel, lors de l'assemblage des deux parties de boîtier (2, 3), le module de raccordement interchangeable (AM1-AM3, AM2'-AM3', AM41, AM41', AM41" , AM51, AM42, AM42', AM42", AM52) peut être assemblé par complémentarité de forme aux faces frontales (6, 7) des bords (4, 5) dans une zone de l'évidement (AN1-AN14, AN6', AN7', AN10', AN11'), **caractérisé en ce que**
le module de raccordement (AM1-AM3, AM2'-AM3', AM41, AM41', AM41" , AM51, AM42, AM42', AM42", AM52) pour l'alimentation électrique peut être conçu de manière différente, et selon lequel la seconde partie de boîtier (3) comporte aussi un évidement (AN4, AN5, AN8, AN9, AN12) du second bord (5) pour recevoir le module de raccordement (AM1-AM3, AM2'-AM3', AM41, AM41', AM41" , AM51, AM42, AM42', AM42'', AM52) en coopération avec l'évidement (AN1, AN2, AN3, AN6, AN7, AN6', AN7', AN19, AN11, AN13, AN14) du premier bord (4).

2. Actionneur (1) selon la revendication 1, dans lequel, pour l'insertion du module de raccordement (AM1-AM3, AM2'-AM3', AM41, AM41', AM41", AM51, AM42, AM42', AM42", AM52), un assemblage rainure-languette est utilisé, les faces frontales (6, 7) des bords (4, 5) dans la zone de l'évidement (AN1-AN14, AN6', AN7', AN10', AN11') forment une languette périphérique et le module de raccordement (AM1-AM3, AM2'-AM3', AM41, AM41', AM41", AM51, AM42, AM42', AM42'', AM52) à insérer dans l'évidement présente une rainure périphérique pour recevoir la languette par complémentarité de forme, la rainure étant formée par une première nervure et une seconde nervure, et, après l'introduction du module de raccordement (AM1-AM3, AM2'-AM3', AM41, AM41', AM41", AM51, AM42, AM42', AM42", AM52) et l'assemblage des deux parties du boîtier (2, 3) la première nervure jouxte un intérieur du boîtier et la seconde nervure est située au ras du boîtier (GH) vers l'extérieur.

3. Actionneur (1) selon la revendication 2, dans lequel la seconde nervure est formée par un corps du module de raccordement (AM1-AM3, AM2'-AM3', AM41, AM41', AM41", AM51, AM42, AM42', AM42", AM52).

4. Actionneur (1) selon l'une quelconque des revendications précédentes, dans lequel l'actionneur est conçu pour recevoir plusieurs modules de raccordement (AM1-AM3, AM2'-AM3', AM41, AM41', AM41", AM51, AM42, AM42', AM42", AM52).

5. Actionneur (1) selon l'une quelconque des revendications précédentes, dans lequel un câble (K1) installé de manière fixe dans l'actionneur est amené par le module de raccordement (AM1-AM3, AM2'-AM3', AM41, AM41', AM41", AM51, AM42, AM42', AM42", AM52).

6. Actionneur (1) selon l'une quelconque des revendications précédentes, dans lequel le module de raccordement (AM1-AM3, AM2'-AM3', AM41, AM41', AM41", AM51, AM42, AM42', AM42'', AM52) est conçu sous forme d'une fiche insérable comportant une série de contacts à borne (AK1-AK4, AK3') destinés à connecter des composants électriques dans le boîtier (GH).

7. Actionneur (1) selon la revendication 6, dans lequel les contacts à borne (AK1-AK4, AK3') sont connectés par une connexion en guirlande.

8. Actionneur (1) selon l'une quelconque des revendications précédentes, selon lequel le module de raccordement (AM1-AM3, AM2'-AM3', AM41, AM41', AM41", AM51, AM42, AM42', AM42", AM52) est conçu sous forme d'une fiche à vis insérable, convenant notamment à la classe de protection IP 54.

9. Actionneur (1) selon l'une quelconque des revendications précédentes, dans lequel le module de raccordement (AM1-AM3, AM2'-AM3', AM41, AM41', AM41", AM51, AM42, AM42', AM42'', AM52) est formé en deux parties, dans lequel la première partie (AM41, AM41', AM41", AM51) peut être insérée par complémentarité de forme dans le boîtier (GH) dans la zone de l'évidement (AN1-AN14, AN6', AN7', AN10', AN11') et comprend au niveau de la partie extérieure du boîtier une douille pour connexion enfichable et la seconde partie (AM42, AM42', AM42", AM52) est conçue sous forme d'une fiche à vis enfichable comportant un connecteur homologue complémentaire à ladite douille.

10. Actionneur (1) selon l'une quelconque des revendications précédentes, dans lequel le module de raccordement (AM1-AM3, AM2'-AM3', AM41, AM41', AM41", AM51, AM42, AM42', AM42'', AM52) est formé en deux parties, dans lequel la première partie peut être insérée par complémentarité de forme dans le boîtier (GH) dans la zone de l'évidement (AN1-AN14, AN6', AN7', AN10', AN11') et comprend au niveau de la partie extérieure du boîtier une douille pour connexion enfichable et la seconde partie est conçue sous forme d'une fiche enfichable comportant un connecteur homologue complémentaire à ladite douille, et ladite fiche est moulée par injection d'une matière plastique électriquement isolante sur un câble amené (K1, K2).

11. Actionneur (1) selon l'une quelconque des revendications précédentes, dans lequel l'actionneur (1) comprend un support de circuit comportant des éléments de contact qui sont conçus de façon à correspondre à des éléments de contact complémentaires du module de raccordement (AM1-AM3, AM2'-AM3', AM41, AM41', AM41", AM51, AM42, AM42', AM42", AM52) afin de permettre un contact électrique lors de l'insertion du module de raccordement (AM1-AM3, AM2'-AM3', AM41, AM41', AM41", AM51, AM42, AM42', AM42", AM52).

12. Actionneur (1) selon la revendication 1, dans lequel, pour l'insertion du module de raccordement (AM1-AM3, AM2'-AM3', AM41, AM41', AM41", AM51, AM42, AM42', AM42", AM52), un assemblage rainure-languette est utilisé, les faces frontales des bords dans la zone de l'évidement (AN1-AN14, AN6', AN7', AN10', AN11') forment une rainure périphérique et le module de raccordement (AM1-AM3, AM2'-AM3', AM41, AM41', AM41", AM51, AM42, AM42', AM42", AM52) à insérer dans l'évidement présente une languette périphérique destinée à être insérée par complémentarité de forme dans la rainure, la rainure étant formée par une première nervure et une seconde nervure, la première nervure jouxtant un intérieur du boîtier et la seconde nervure jouxtant un extérieur du boîtier.

13. Module de raccordement (AM1-AM3, AM2'-AM3', AM41, AM41', AM41'', AM51, AM42, AM42', AM42'', AM52) pour une amenée de câble à un actionneur (1) selon l'une quelconque des revendications 1 à 12, dans lequel le module de raccordement (AM1-AM3, AM2'-AM3', AM41, AM41', AM41", AM51, AM42, AM42', AM42'', AM52) peut être introduit dans un évidement d'un bord d'une partie de boîtier (2, 3) et, lors de l'assemblage des deux parties du boîtier (2, 3), le module de raccordement (AM1-AM3, AM2'-AM3', AM41, AM41', AM41", AM51, AM42, AM42', AM42", AM52) peut être assemblé par complémentarité de forme avec les faces frontales (6, 7) des bords (4, 5) dans une zone de l'évidement (AN1-AN14, AN6', AN7', AN10', AN11'), le module de raccordement pour l'alimentation électrique (AM1-AM3, AM2'-AM3', AM41, AM41', AM41", AM51, AM42, AM42', AM42'', AM52) pouvant être conçu de manière différente.

14. Dispositif d'actionnement d'organes de réglage, le dispositif comprenant :
un actionneur (1) selon l'une quelconque des revendications 1 à 12, qui comporte un boîtier (GH) présentant une première partie de boîtier (2) et une seconde partie de boîtier (3), les deux parties de boîtier (2, 3) comportant chacune un bord (4, 5) pourvu chacun d'une face frontale (6, 7), et lors de l'assemblage des deux parties de boîtier (2, 3), les deux faces frontales (6,7) étant disposées face à face, et la première et la seconde partie de boîtier (2, 3) pouvant être assemblées de manière amovible, et
un module de raccordement (AM1-AM3, AM2'-AM3', AM41, AM41', AM41", AM51, AM42, AM42', AM42", AM52) pour une amenée de câble à l'actionneur, ledit module de raccordement (AM1-AM3, AM2'-AM3', AM41, AM41', AM41", AM51, AM42, AM42', AM42'', AM52) pouvant être introduit dans un évidement du premier bord (4) de la première partie de boîtier (2) et dans lequel, par un assemblage des deux parties de boîtier (2, 3), le module de raccordement interchangeable (AM1-AM3, AM2'-AM3', AM41, AM41', AM41", AM51, AM42, AM42', AM42", AM52) peut être assemblé par complémentarité de forme avec les faces frontales (6, 7) des bords (4, 5) dans une zone de l'évidement (AN1-AN14, AN6', AN7', AN10', AN11'), et selon lequel le module de raccordement (AM1-AM3, AM2'-AM3', AM41, AM41', AM41", AM51, AM42, AM42', AM42", AM52) pour l'alimentation électrique peut être conçu de manière différente.

15. Dispositif selon la revendication 14, dans lequel le module de raccordement (AM1-AM3, AM2'-AM3', AM41, AM41', AM41", AM51, AM42, AM42', AM42", AM52) est un module de raccordement (AM1-AM3, AM2'-AM3', AM41, AM41', AM41", AM51, AM42, AM42', AM42'', AM52) selon la revendication 13.
